# EUROPEAN PATENT APPLICATION

(11) **EP 2 216 811 A2**
(43) Date of publication of application: **11.08.2010**
(21) Application number: 09177557.7
(22) Date of filing: 30.11.2009
(51) Int. Cl.: H01L 21/8244, H01L 27/11, H01L 27/12, H01L 29/78, G11C 11/412

(54) **Radiation hardened SRAM cells with floating bodies**

(30) Priority: 10.02.2009 US 368880
(71) Applicant: Honeywell International Inc., Morristown, NJ 07962 (US)
(72) Inventor: Larsen, Bradley J., Morristown, NJ 07962-2245 (US); Randazzo, Todd A., Morristown, NJ 07962-2245 (US); Yue, Cheisan, Morristown, NJ 07962-2245 (US)
(74) Representative: Buckley, Guy Julian

(57) **Abstract**

A CMOS SRAM memory element comprising silicon-on-insulator MOSFET transistors (201-206) is disclosed wherein at least one of the MOSFET transistors is configured such that the body of the transistor is not connected to a voltage source and is instead permitted to electrically float. Implementations of the disclosed memory element with increased immunity to errors caused by heavy ion radiation are also disclosed.

## Description

### GOVERNMENT RIGHTS

The United States government may have rights in this invention pursuant to contract number DTRA01-03-D-0018-0006 with the Defense Threat Reduction Agency.

### FIELD OF INVENTION

The invention relates to electronic circuits arranged as memory cells, and more particularly, to memory cells capable of resisting errors caused by radiation.

### BACKGROUND

When charged particles, such as those found in heavy ion radiation, pass through a complementary metal-oxide-semiconductor (CMOS) memory cell, a state of data stored in the CMOS memory cell can change. This phenomenon, known as an "upset", can be particularly problematic because the upset is often undetectable. As a result, data stored in a memory cell can be lost or altered.
Such losses and alterations can cause a myriad of problems, including improper operation of software, erroneous results to calculations, and other errors.

A sensitivity of CMOS memory cells to upsets increases as the memory cells are scaled to smaller geometries and lower power supplies. Static random access memory (SRAM) cells that utilize silicon-on-insulator (SOI) field effect transistors (FETs), while typically less sensitive to charged particle upsets than SRAMs implemented in junction isolated 'bulk" silicon, also exhibit increased sensitivity when the SRAM cells are scaled to smaller geometries and lower power supply voltages. In addition, traditional methods of hardening SRAM memory cells can be difficult to implement within memory cells that are scaled to smaller device geometries.

### SUMMARY

In a first aspect, the present invention provides a complementary metal-oxide semiconductor (CMOS) memory element comprising a plurality of silicon-on-insulator (SOI) metal-oxide semiconductor field-effect transistors (MOSFETs), wherein a body of at least one of the plurality of the SOI MOSFETs is not electrically connected to a reference voltage in the CMOS memory element.

In a second aspect, the present invention provides a CMOS static random access memory (SRAM) memory cell comprising a plurality of MOSFETs, wherein none of the bodies of the plurality of MOSFETs are electrically connected to another component in the CMOS memory cell.

In a third aspect, the present invention provides a CMOS SRAM memory cell comprising a plurality of floating-body MOSFETs, a first resistor and a second resistor, and a delay element. The first resistor and the second resistor are arranged such that a first terminal of the first resistor is electrically connected to an input connection on a first inverter in the CMOS SRAM memory cell, and a second terminal of the first resistor is electrically connected to an output connection in a second inverter in the CMOS SRAM memory cell. The delay element included in the CMOS SRAM memory cell is arranged such that a first terminal of the delay element is electrically connected to a terminal on a first component of the CMOS SRAM memory cell and a second terminal of the delay element is electrically connected to a terminal on a second component of the CMOS SRAM memory cell.

### BRIEF DESCRIPTION OF FIGURES

Figure 1 shows a schematic of an example memory cell with body ties.

Figure 2 shows a schematic of an example system in accordance with one embodiment of the invention.

### DETAILED DESCRIPTION

When charged particles, such as those found in heavy ion radiation, pass through a CMOS memory element, the memory cell can change state, resulting in a loss or alteration of data stored in the memory cell, and is referred to as a single event upset (SEU). The susceptibility of a CMOS memory cell to SEUs increases as the cell is scaled to smaller geometries and designed to use lower power supplies. SRAM cells that utilize silicon-on-insulator (SOI) field effect transistors (FETs), while typically less sensitive to charged particle upsets than SRAMs implemented in junction isolated 'bulk" silicon, also exhibit increased sensitivity when the SRAM cells are scaled to smaller geometries and lower power supply voltages.

Often charged particle induced soft errors may be corrected for with various forms of redundancy such as TMR (triple mode redundancy) or EDACs (error detection and correction). In many cases it is favorable to have a memory element which is inherently immune to soft error upsets. Fabrication of the CMOS transistors in a thin SOI (Silicon on Insulator) film dramatically limits the "volume" of silicon in which charge can be generated and collected to influence circuit operation. However, even in the case of SOI CMOS SRAMs, additional design features may be required to further immunize the memory from soft errors, in order to achieve error rates are extremely low. The most common of these techniques are to add capacitance, thus increasing the amount of deposited charge required to upset the cell, or to add delay, which increases the time required for a charged-particle-induced voltage glitch to be latched into the cell, or to add both capacitance and delay.

The most common process and device implementation of SOI FETs is known as "partially depleted SOI." In general this means that when the gate potential of the FET is at the threshold potential, there still exists between the source and drain of the transistor a charge neutral region which has not been depleted out by the inversion depletion layer. This region is referred to as the "body" of the transistor, and in many applications it is permitted to simply float; no deliberate attempt to hook up the body to a fixed potential such as V_{dd} for p-channel FET and Vₛₛ for n-channel FETs is taken. In applications where steps are being taken to immunize the SRAM cell to charged particle induced soft errors, however, this is not the case. In order to avoid parasitic bipolar multiplication of the deposited charge, steps are taken to tie the transistor "body" to a fixed potential through relatively low resistance connections, again typically Vₛₛ for the n-channel FETs and V_{dd} for the p-channel FETs. These low resistance connections to the body of each of the SOI FETs are referred to as "body ties." While body ties can improve SEU immunity of a memory cell, the additional connections required to implement the body ties can increase the layout area required for the memory cell. In addition to increasing the amount of area necessary to implement the memory cell, the increased layout area may also increase the power requirements of the memory cell, degrade the performance of the memory cell, and increase the production cost.

To date, CMOS SOI SRAM cells which have been intentionally immunized to charged particle induced soft errors through the addition of capacitance or delay or both have been constructed from body-tie FETs. However, as disclosed herein, a floating body SRAM cell SEU hardened through the addition of capacitance or delay or both can take advantage of the area and performance characteristics of floating body configurations.

In general, the present invention allows for one or more MOSFET bodies in a memory element, such as an SRAM cell, allowed to electrically float. At the same time, the memory element is hardened to soft errors through the application of resistor isolation techniques, the addition of capacitance, the addition of delay elements, or through a combination of techniques. By eliminating one or more body ties from the circuit, a smaller layout area can be used to implement the memory cell, which can improve the performance of the memory cell is and reduce the power consumption and manufacturing cost of the memory cell. Through the implementation of soft-error hardening techniques, the memory elements can be constructed using floating-body MOSFETs while reducing the likelihood of soft errors.

In a first aspect of the invention, a complementary metal-oxide-semiconductor (CMOS) memory element comprises a plurality of silicon-on-insulator (SOI) metal-oxide-semiconductor field-effect transistors (MOSFETs). Within the memory element, a body of at least one of the SOI MOSFETs is not electrically connected to a reference voltage in the CMOS memory element. In one example, the body of at least one of the plurality of SOI MOSFETs is not electrically connected to any other component or voltage supply, and electrically floats. In a second example, none of the bodies of the plurality of SOI MOSFETs may be connected to a reference voltage in the CMOS memory element. In this example, all of the bodies of the SOI MOSFETs electrically float.

In another example embodiment, the bodies of one or more MOSFETS may be connected to a predetermined voltage, such as a bias voltage below Vₛₛ for the n-channel transistor bodies or a bias above V_{dd} for the p-channel bodies. Such a configuration allows adjustment of a threshold potential and may be used to reduce the dc power consumption of the memory element.

One of the types of memory elements that can be formed in accordance with the first aspect of the invention is a static random access memory (SRAM) memory cell. Example embodiments of the SRAM memory cells include memory cells comprising many SOI MOSFET transistors, and at least one of the transistors includes a floating body transistor.

As is well known in the art, the MOSFETs in a CMOS SRAM are arranged to form at least two inverters. Immunity of the SRAM memory cell to SEUs can be improved by resistor-isolating an output of a first inverter in the SRAM memory cell from an input of a second inverter in the SRAM cell. In one example utilizing resistor-isolation, a resistor is added to the CMOS memory element, and a first terminal of the resistor is electrically connected to an input connection of a first inverter in the CMOS memory element and a second terminal of the resistor is electrically connected to an output connection of a second inverter in the CMOS memory element. In another embodiment, a second resistor is electrically connected between an input connection of the second inverter and the output connection of the first inverter in the CMOS memory element. In example embodiments utilizing resistor-isolation, a charge deposited by a heavy ion is not beta-multiplied, because one of the floating-body transistors will saturate providing the CMOS memory cell with a level of immunity to SEUs.

Example embodiments that include resistor-isolation may provide further immunity to SEUs by including delay elements in the CMOS memory element. The delay element is included in the CMOS memory cell such that a first terminal of the delay element is electrically connected to a terminal on a first component of the CMOS memory element and a second terminal of the delay element is electrically connected to a terminal on a second component of the CMOS memory cell. In example embodiments, the delay elements can include one or more resistors, one or more capacitors, or a combination of one or more resistors and one or more capacitors, including combinations of resistors and capacitors and at least one terminal of a resistor and one terminal of a capacitor are electrically connected.

In another aspect, a CMOS SRAM memory cell comprises a plurality of MOSFETs and none of the bodies of the plurality of MOSFETs are electrically connected to another component in the CMOS memory cell. CMOS SRAM memory cells in accordance with this aspect may also utilize resistor-isolation, as described above, to provide the memory cell with additional SEU immunity.
Delay elements, as described above, may also be included in the CMOS SRAM memory cells to further improve SEU immunity.

In yet another aspect, a CMOS SRAM memory cell comprises a plurality of floating-body MOSFETs, a first resistor and a second resistor, and a delay element. In accordance with this aspect, the first resistor and the second resistor are included in the CMOS SRAM cell such that a first terminal of the first resistor is electrically connected to an input connection on a first inverter in the CMOS SRAM memory cell, a second terminal of the first resistor is electrically connected to an output connection in a second inverter in the CMOS SRAM memory cell, a first terminal of the second resistor is electrically connected to an input connection on the second inverter in the CMOS SRAM memory cell, and a second terminal of the second resistor is electrically connected to an output connection on the first inverter in the CMOS SRAM memory cell. The delay element is included in CMOS SRAM memory cell such that a first terminal of the delay element is electrically connected to a terminal on a first component of the CMOS SRAM memory cell and a second terminal of the delay element is electrically connected to a terminal on a second component of the CMOS SRAM memory cell. Similar to the other aspects of the invention, the delay elements used in example embodiments of CMOS SRAM memory cells may comprise at least one resistor, at least one capacitor, or a combination of at least one resistor and at least one capacitor electrically connected together.

When a resistor is used as part of a delay element, the resistor or the resistor-capacitor pair acts to increase the loop delay, sometimes referred to as the cross-coupled inverter delay. This increase in loop delay increases the memory cell's resistance to soft errors by increasing the magnitude and duration of the charged particle event necessary to cause the cell to latch in a bad state.
Particularly in configurations that use floating body MOSFETs, using resistors to isolate the output of one inverter from the input of the other allows the parasitic bipolar device to drop into saturation, thus preventing the multiplication of the deposited charge. Unlike memory-cell configurations that utilize bulk or body-tie SOI MOSFETs, where the p-well (n-channel) or n-well (p-channel) of the MOSFETS are electrically coupled to a fixed potential, floating body configuration avoid errors related to the base or channel, potential from rising above the emitter or source potential.

### EXAMPLES

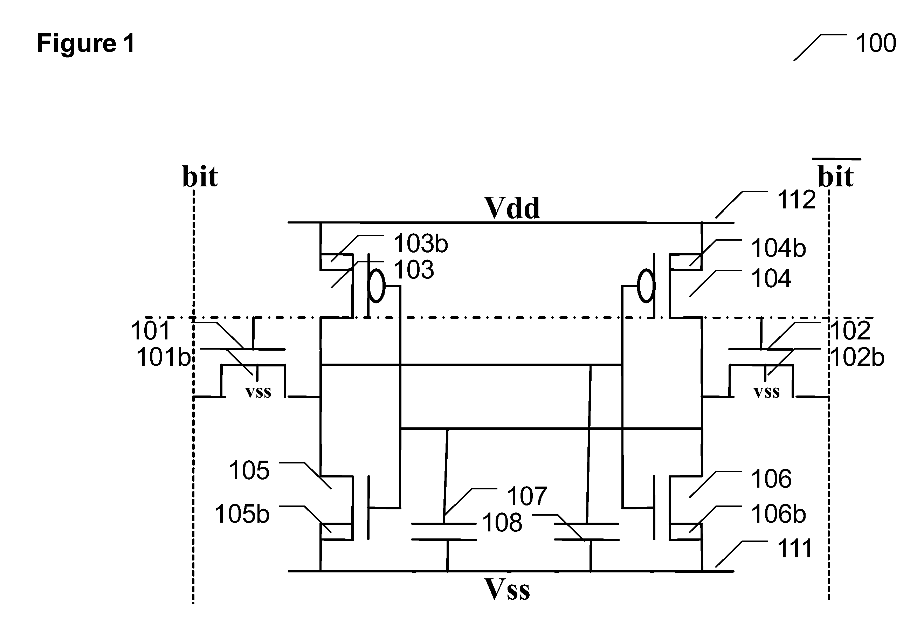

Figure 1 depicts a six-transistor CMOS SRAM memory cell 100 according to the prior art. In memory cell 100, each of the transistors 101-106 are configured such that their body connections 101b-106b are electrically connected to either the V_{dd} supply rail 112 or the Vₛₛ supply rail 111. Specifically, the bodies of the PFET transistors 103 and 104 are electrically connected to the V_{dd} supply rail 112, and the bodies of the NFET transistors 105 and 106 are electrically connected to the Vₛₛ supply rail 111. Capacitors 107 and 108, are used as delay elements to provide a level of immunity to upsets caused by heavy ion radiation. In this configuration, low resistance electrical connections with the bodies of all the transistors prevent the parasitic bipolar devices from turning on, and eliminates a "history effect" associated with dynamic changes in the body potential by adjusting the threshold voltage of the transistors, and eliminate the additional drain-induced barrier lowering associated with drain-body coupling.

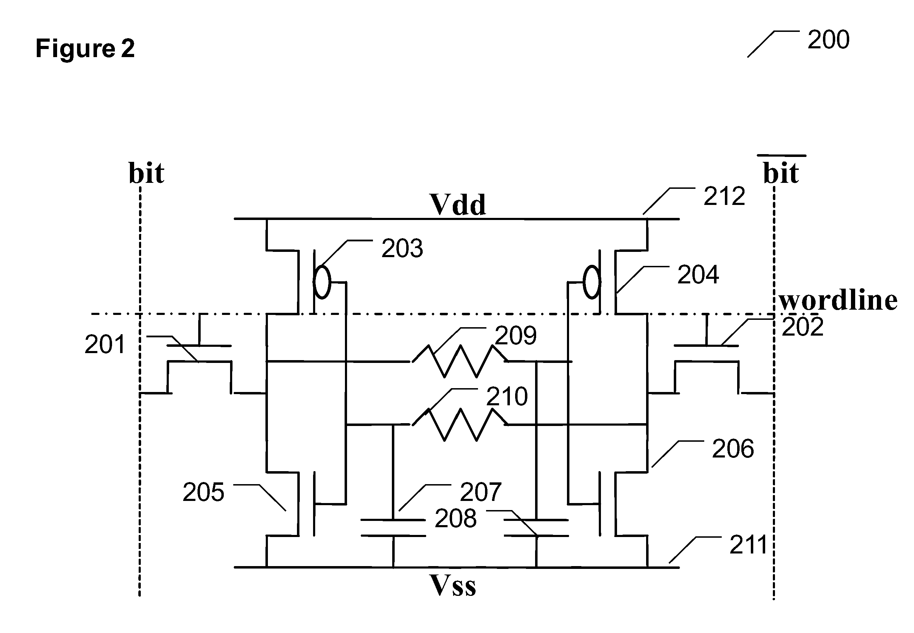

Figure 2 depicts a six-transistor CMOS SRAM memory cell 200. In memory cell 200, each of the transistors 201-206 are configured such that there are no electrical connections between the body of transistors 201-206 and the V_{dd} supply rail 212 or the Vₛₛ supply rail 211. Resistors 209 and 210 are used to resistor isolate the input of transistors 203 and 205 from the output of transistors 204 and 206, and the input of transistors 204 and 206 from the output of transistors 203 and 205. Resistors 209 and 210 are also electrically connected to capacitors 207 and 208 which act as delay elements, providing additional hardening against SEUs.

## Claims

1. A complementary metal-oxide-semiconductor (CMOS) memory element comprising:
a plurality of silicon-on-insulator (SOI) metal-oxide-semiconductor field-effect transistors (MOSFETs), wherein a body of at least one of the plurality of SOI MOSFETs is not electrically connected to a reference voltage in the CMOS memory element; and
a resistor, wherein a first terminal of the resistor is electrically connected to an input connection of a first inverter in the CMOS memory element and a second terminal of the resistor is electrically connected to an output connection in a second inverter in the CMOS memory element.

2. The CMOS memory element of claim 1, wherein none of the bodies of the plurality of SOI MOSFETs are connected to a reference voltage in the CMOS memory element.

3. The CMOS memory element of any of claims 1 or 2, wherein the SOI MOSFETs are electrically connected to form a static random access memory (SRAM) memory cell.

4. The CMOS memory element of claim 3, further comprising a delay element, wherein a first terminal of the delay element is connected to a terminal on a first component of the CMOS memory element and a second terminal of the delay element is connected to a terminal on a second component of the CMOS memory element.

5. The CMOS memory element of claim 4, wherein the delay element comprises at least one of the resistor or a capacitor.

6. The CMOS memory element of claim 4, wherein the delay element comprises the resistor and a capacitor, wherein a terminal of the resistor is electrically connected to a terminal on the capacitor.

7. The CMOS memory element of claim 3, wherein the resistor comprises a a first isolation resistor, the CMOS memory element further comprising a second isolation resistor, wherein:
a first terminal of the second resistor is electrically connected to an input connection on the second inverter in the CMOS memory element; and
a second terminal of the second resistor is electrically connected to an output connection on the first inverter in the CMOS memory element.

8. A complementary metal-oxide-semiconductor (CMOS) static random access memory (SRAM) memory cell comprising:
a plurality of metal-oxide-semiconductor field-effect transistors (MOSFETs), wherein none of the bodies of the plurality of MOSFETs are electrically connected to another component in the CMOS memory cell; and
a first resistor, wherein a first terminal of the first resistor is electrically connected to an input connection of a first inverter in the CMOS SRAM memory cell and a second terminal of the first resistor is electrically connected to an output connection in a second inverter in the CMOS SRAM memory cell.

9. The CMOS SRAM memory cell of claim 8, further comprising a second resistor, wherein:
a first terminal of the second resistor is electrically connected to an input connection on the second inverter in the CMOS SRAM memory cell; and
a second terminal of the second resistor is electrically connected to an output connection on the first inverter in the CMOS SRAM memory cell.

10. The CMOS SRAM memory cell of any of claims 8 or 9, further comprising a delay element, wherein a first terminal of the delay element is electrically connected to a terminal on a first component of the CMOS SRAM memory cell and a second terminal of the delay element is electrically connected to a terminal on a second component of the CMOS SRAM memory cell.
